# EUROPEAN PATENT APPLICATION

(11) **EP 4 803 526 A1**
(43) Date of publication of application: **09.09.2026**
(21) Application number: 25188723.8
(22) Date of filing: 10.07.2025
(51) Int. Cl.: C07F 7/22, G03F 7/004

(54) **CLUSTER COMPOUND OR SALT THEREOF AND PHOTORESIST COMPOSITION INCLUDING THE SAME**

(30) Priority: 07.03.2025 KR 20250029922
(71) Applicant: Industry Foundation of Chonnam National University, Gwangju 61186 (KR); Korea Research Institute of Chemical Technology, Daejeon 34114 (KR)
(72) Inventor: JEONG, Hyun-Dam, 61182 Gwangju (KR); YUN, Hyeok, 59454 Boseong-eup (KR); KIM, Cheol-Min, 17084 Yongin-si (KR); HEO, Kyuyoung, 34114 Daejeon (KR)
(74) Representative: Kraus & Lederer PartGmbB

(57) **Abstract**

Provided are a cluster compound or a salt thereof, and a photoresist composition including the same. Since the cluster compound according to an example embodiment increases the density of a thin film by a hydrogen bond between clusters to suppress diffusion of produced secondary electrons and has a ring structure to have excellent etching resistance and mechanical strength, the compound may form a photoresist pattern having significantly improved EUV sensitivity.

## Description

### CROSS-REFERENCE TO RELATED APPLICATIONS

This application claims priority under 35 U.S.C. §119 to Korean Patent Application No. 10-2025-0029922, filed on March 07, 2025, in the Korean Intellectual Property Office, the disclosure of which is incorporated herein by reference in its entirety.

### TECHNICAL FIELD

The following disclosure relates to a cluster compound or a salt thereof, and a photoresist composition including the same.

### BACKGROUND

Lithography using a photoresist composition is being implemented in a patterning process of semiconductor manufacture. As a lithography light source, I-line (365 nm), KrF (248 nm), and ArF (193 nm) have been mainly used. Due to the high integration of a semiconductor, formation of ultrafine patterns is required, and for this, the wavelength of a light source is gradually becoming shorter. In particular, as a next-generation light source for manufacturing an ultra-highly integrated semiconductor, extreme ultraviolet (EUV) rays having a wavelength of 13.5 nm is emerging.

In an EUV lithography process, photons having a strong energy of 92 eV (13.5 nm) are irradiated, and unlike a lithography process of a conventional light source which expresses a dissolution contrast of a photoresist by a photochemical reaction, the dissolution contrast of a photoresist which is expressed by a radiochemical reaction by secondary electrons produced after EUV irradiation is used.

Conventional ArF positioned in an ultraviolet area may be captured by refraction using a lens. However, EUV is close to X-rays and is difficult to refract. Therefore, light is captured using reflection. The reflection efficiency of a reflector used in EUV lithography equipment is about 60-80% [Proc. of SPIE, 9658, 965814-2, 2015], and the amount of light reaching a wafer based on 8 reflectors is about 5.8% of a light source. In addition, the number of photons per unit volume based on the same energy incidence is only 7% of conventional ArF. Therefore, use of a photoresist having high EUV sensitivity is needed.

Studies of an EUV photoresist are largely divided into a chemically amplified resist (CAR) type and a non-CAR type. The CAR type is a photoresist process which increases a PAG concentration used in KrF and ArF to increase a resin response amount to extreme ultraviolet rays, and the non-CAR type is a photoresist process which increases an extreme ultraviolet absorbance amount of molecules included in metal using a photoresist.

Since most of the CAR types formed by organic resins are used after being coated with a thin film which is thick enough to withstand etching ions, as a pattern line width decreases, the aspect ratio of the photoresist gradually increases, and thus, when sufficient mechanical strength is not secured, the formed pattern collapses by the surface tension of a developing solution. However, since the non-CAR type has better etching resistance and an etch rate than organic resins, sufficient etching resistance is secured only with a relatively thin film and the aspect ratio also becomes lower than the organic resin, so that mechanical strength is high. Therefore, the advantages of the non-CAR become more prominent in high-NA and hyper-NA which have a narrow focus depth and should have a photoresist thickness of less than 40 nm, and development of a non-CAR type inorganic photoresist having good performance is needed.

As the non-CAR type inorganic photoresist, cluster-type molecules having 2 to 10 metal atoms are being actively studied. For example, there are zinc oxo clusters, hafnium oxo clusters, tin oxo clusters, and the like, and among them, clusters including tin which is relatively abundant and has a large photoionization cross section are receiving attention. Most of the tin oxo clusters is prepared using alkyl tin in order to secure solubility in an organic solvent, and due to the toxicity of the alkyl tin, the tin oxo clusters may adversely affect the environment.

Accordingly, recently, non-alkyl tin oxo clusters which secure solubility in an organic solvent by forming a tin-nitrogen bond based on an azole functional group instead of a tin-carbon bond have been developed. However, due to the stable structure of molecules, when reactivity to an electron beam is low and there is little interaction between organic ligands, it is difficult to secure coatability, and the density of a material is lowered, so that it is difficult to suppress absorbance and secondary battery diffusion for extreme ultraviolet rays.

Therefore, development of a new inorganic cluster compound having excellent etching resistance and significantly improved EUV sensitivity is needed.

### SUMMARY

An embodiment of the present disclosure is directed to providing a cluster compound having excellent etching resistance and mechanical strength and having significantly improved EUV sensitivity, and a method for preparing the same.

Another embodiment of the present disclosure is directed to providing a photoresist composition including the cluster compound and a method for forming a photoresist pattern using the same.

In one general aspect, a cluster compound represented by any one of the following Chemical Formulae 1 to 3 or a salt thereof is provided:

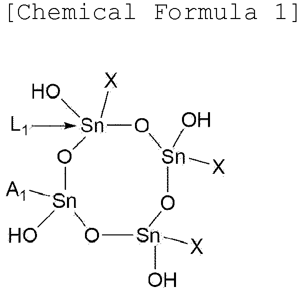

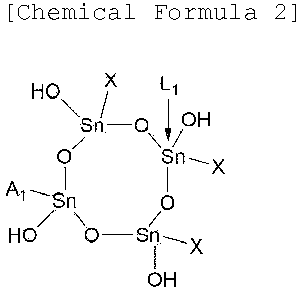

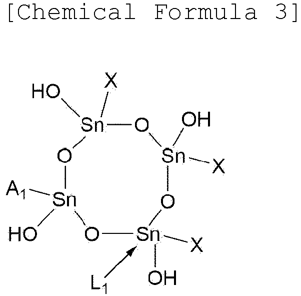

wherein X is a halogen, A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and L₁ is a neutral or ionic ligand.

In an example embodiment, A₁ may be CH₃COO⁻.

In an example embodiment, L₁ may be any one or more selected from the group consisting of pyrazole (C₃N₂H₄), pyridine (C₅NH₅), and imidazole (C₃N₂H₄).

In an example embodiment, the cluster compound or the salt thereof may have an average particle diameter of 0.5 nm to 5 nm in an organic solvent.

In an example embodiment, all or a part of X may be substituted by any one or more selected from the group consisting of R₁COO⁻, CO₃²⁻, and HCO₃⁻ in which R₁ is C1-C5 alkyl.

In an example embodiment, the cluster compound may be for forming a photoresist pattern.

In an example embodiment, the photoresist pattern may be an EUV photoresist pattern.

In another general aspect, a photoresist composition includes the cluster compound or the salt thereof.

In another general aspect, a method for preparing a cluster compound or a salt thereof includes: 1) preparing a solution including a tin halogen compound, water, and a neutral or ionic ligand; and 2) dissolving the solution in a solvent to prepare a cluster compound represented by any one of the following Chemical Formulae 1 to 3 or a salt thereof:

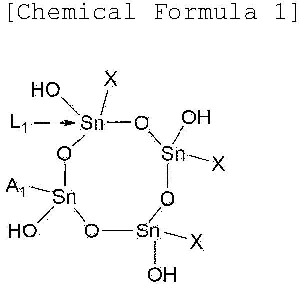

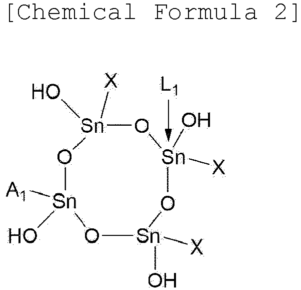

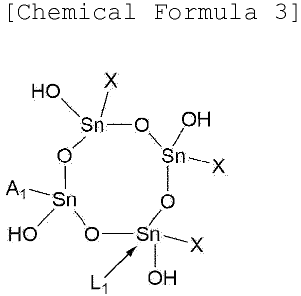

wherein X is a halogen, A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and L₁ is a neutral or ionic ligand.

In an example embodiment, the neutral or ionic ligand may be any one or more selected from the group consisting of pyrazole (C₃N₂H₄), pyridine (C₅NH₅), and imidazole (C₃N₂H₄).

In an example embodiment, the solvent may include any one or more selected from the group consisting of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid.

In an example embodiment, the tin halogen compound may be included at 0.01 mol to 1 mol with respect to 1 mol of the neutral or ionic ligand.

In another general aspect, a method for forming a photoresist pattern includes: (a) applying the photoresist composition of claim 8 on a substrate and drying to form a photoresist film; (b) exposing the photoresist film to active light; and (c) developing the exposed photoresist film.

In an example embodiment, the pattern may be a negative pattern.

In an example embodiment, the active light may be an electron beam or extreme ultraviolet rays.

In still another general aspect, a semiconductor device includes a photoresist pattern formed by the method for forming a photoresist pattern.

Other features and aspects will be apparent from the following detailed description, the drawings, and the claims.

### BRIEF DESCRIPTION OF THE DRAWINGS

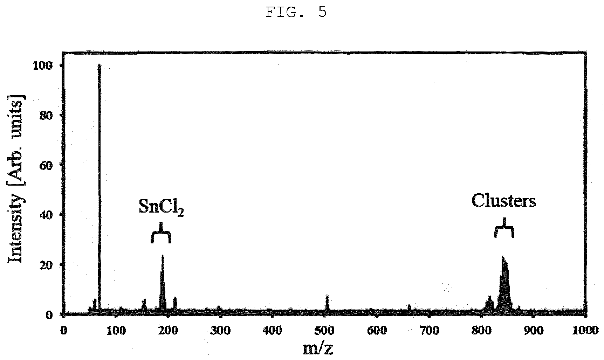

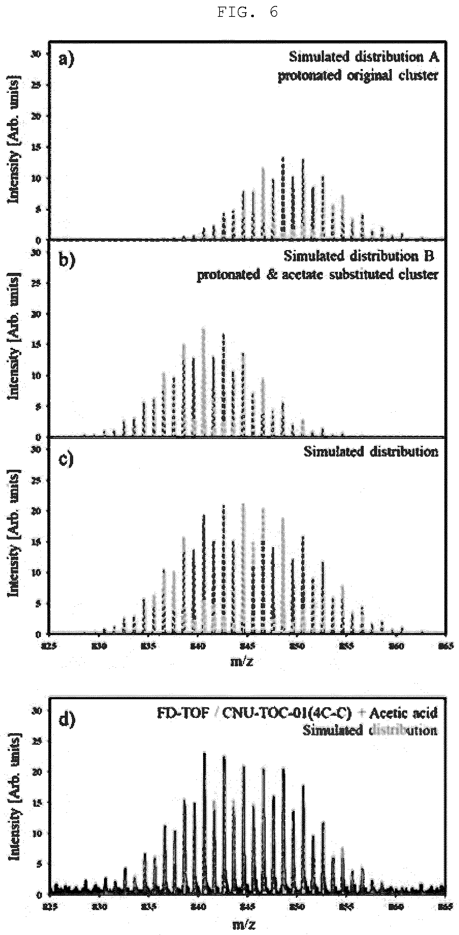

FIG. 1 shows results of analyzing the cluster compound of Preparation Example 1 with a field desorption mass spectrometer.
FIG. 2 shows an enlarged view of an area from 830 Da to 870 Da of the results of FIG. 1. Specifically, the black spectrum is the spectrum of the cluster compound of Preparation Example 1, and the red spectrum is the spectrum of the compound shown in the drawing.
FIG. 3 shows an intensity depending on a scattering vector (q) by analyzing the cluster compound of Preparation Example 1 with small-angle X-ray scattering.
FIG. 4 shows a particle size distribution of the cluster compound of Preparation Example 1 after converting the results of FIG. 3 by a log normal distribution.
FIG. 5 shows the results of analyzing the cluster compound prepared in Example 1 with a field desorption mass spectrometer. Herein, the peaks of the cluster compound of Preparation Example 1 are mixed due to some cluster compounds of which the ligands are not completely substituted with acetic acid.
(a) to (d) of FIG. 6 show enlarged views of an area from 825 Da to 865 Da of the results of FIG. 5. Specifically, (a) and (b) of FIG. 6 are the peaks of the cluster compound before and after ligand substitution occurred, respectively, and each peak was fitted depending on its existence ratio and is shown by simulation. In addition, (c) of FIG. 6 is shown after summing the graphs of (a) and (b) of FIG. 6, and (d) of FIG. 6 compares the spectra of the cluster compounds. In (d) of FIG. 6, the black spectrum is the spectrum of the cluster compound of Example 1, and the red spectrum is the spectrum of (c) of FIG. 6.

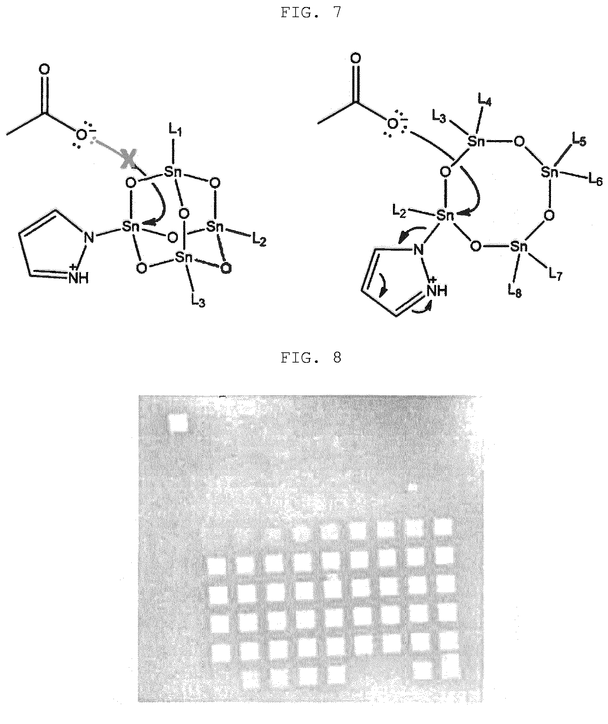

FIG. 7 shows a substitution reaction of an S_{N}2 type in a diamond-shaped structure and in a ring-shaped structure. Since in the diamond-shaped structure (left side), the back side of tin is closed, an S_{N}2-type substitution reaction may not occur.
FIG. 8 is a photograph in which the photoresist film manufactured in Example 3 through 5 keV electron beam lithography is confirmed by an optical microscope.

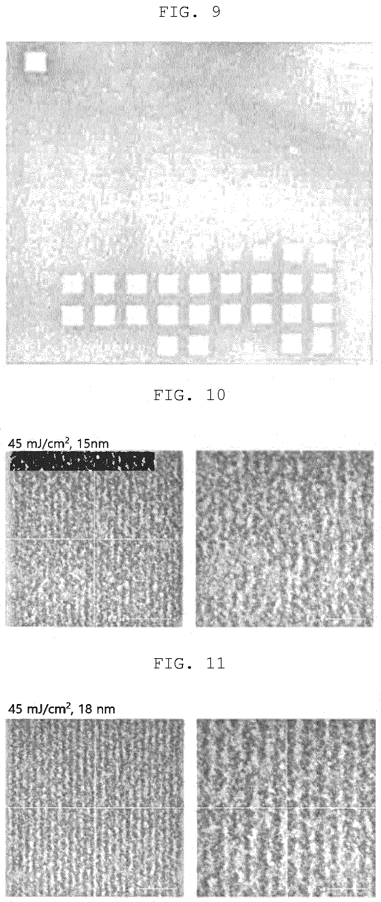

FIG. 9 is a photograph in which the photoresist film manufactured in Example 4 through 5 keV electron beam lithography is confirmed by an optical microscope.

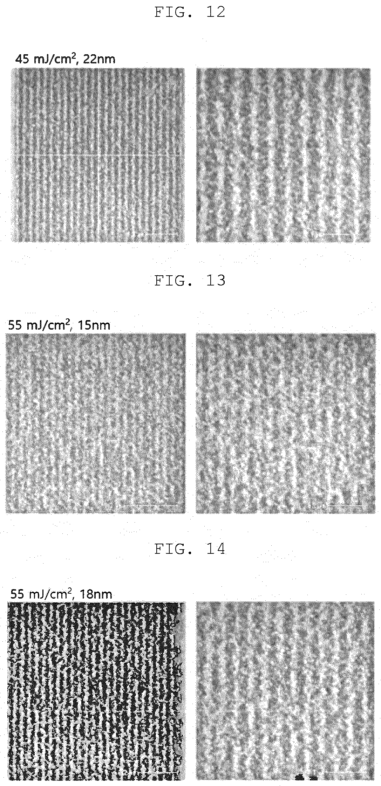

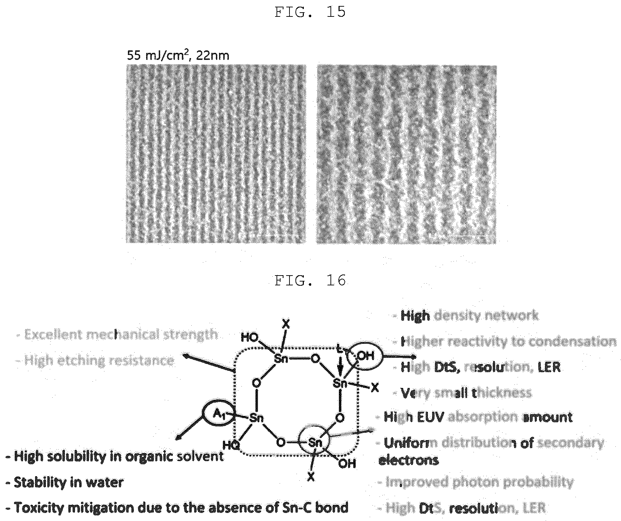

FIGS. 10 to 15 are SEM images in which the photoresist film manufactured in Example 3 through EUV lithography is confirmed by a scanning electron microscope. Specifically, FIG. 10 shows a 15 nm half pitch pattern with an exposure dose of 45 mJ/cm², FIG. 11 shows a 18 nm half pitch pattern with an exposure dose of 45 mJ/cm², and FIG. 12 shows a 22 nm half pitch pattern with an exposure dose of 45 mJ/cm². FIG. 13 shows a 15 nm half pitch pattern with an exposure dose of 55 mJ/cm², FIG. 14 shows a 18 nm half pitch pattern with an exposure dose of 55 mJ/cm², and FIG. 15 shows a 22 nm half pitch pattern with an exposure dose of 55 mJ/cm².
FIG. 16 shows a molecular structure of the cluster compound according to an example embodiment.

### DETAILED DESCRIPTION OF EMBODIMENTS

Since the embodiments described in the present specification may be modified in many different forms, the technology according to an example embodiment is not limited to the embodiments set forth herein. Furthermore, throughout the specification, unless otherwise particularly stated, the word "comprising", "including", "containing", "being provided with", or "having" does not mean the exclusion of any other constituent element, but rather means further inclusion of other constituent elements, and elements, materials, or processes which are not further listed are not excluded.

The numerical range used in the present specification includes all values within the range including the lower limit and the upper limit, increments logically derived from the form and spanning of a defined range, all double limited values, and all possible combinations of the upper limit and the lower limit in the numerical range defined in different forms. As an example, when it is defined that a content of a composition is 10% to 80% or 20% to 50%, it should be interpreted that a numerical range of 10% to 50% or 50% to 80% is also described in the specification of the present specification. Unless otherwise defined in the present specification, values which may be outside a numerical range due to experimental error or rounding off of a value are also included in the defined numerical range.

The term "halo" used in the present specification refers to a state in which one or more hydrogen atoms in a functional group are substituted with a halogen atom. For example, in the case of haloalkyl, it includes -CF₃, -CHF₂, -CH₂F, -CBr₃, - CHBr₂, -CH₂Br, -CCl₃, -CHCl₂, -CH₂Cl, -CHI₂, -CH₂I, -CH₂-CF₃, - CH₂-CHF₂, -CH₂-CH₂F, -CH₂-CBr₃, -CH₂-CHBr₂, -CH₂-CH₂Br, and the like, but is not necessarily limited thereto.

The terms used in the present specification "carboxylic acid", "carboxyl", and "carboxy" refer to -COOH.

Hereinafter, unless otherwise particularly defined in the present specification, "about" may be considered as a value within 30%, 25%, 20%, 15%, 10%, 5%, 3%, 2%, 1%, or 0.5% of a stated value.

Hereinafter, the present disclosure will be described in detail (with reference to the accompanying drawings). However, it is only illustrative, and the present disclosure is not limited to the specific embodiments which are illustratively described in some embodiments of the disclosed technology.

When a conventional cluster compound including a functional group such as an alkyl group or allyl group is irradiated with low wavelength (high energy) light such as electron beam or EUV, a radical produced based on Sn-C bond cutting is connected to form a pattern. The conventional cluster has a small size to secure excellent LER characteristics and includes atoms having an excellent photoionization cross section, such as tin, to better EUV absorption coefficient and etching resistance than a conventional organic photoresist. However, even allyl tin oxo clusters which are known to be the most sensitive have a dose to size for EUV irradiation of a level of 180 mJ/cm², and thus, the EUV sensitivity is not sufficiently high and is inappropriate for real use as a photoresist material. Considering that when an alkyl group is used as a capping ligand of inorganic nanoparticles, there is a restriction on a ligand exchange reaction as compared with the case of using an alkyl group as a capping ligand of nanoparticles, this is because a bond between a carbon atom and a metal atom is not easily dissociated in a high energy light irradiation process even in a metal oxo cluster compound. The undissociated alkyl group interferes with a crosslinking reaction between clusters, so that the pattern is not formed properly.

An example embodiment provides a cluster compound represented by any one of the following Chemical Formulae 1 to 3 or a salt thereof:

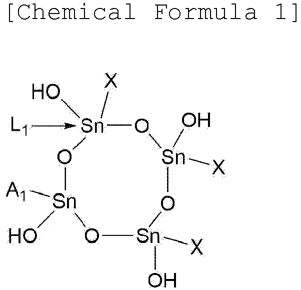

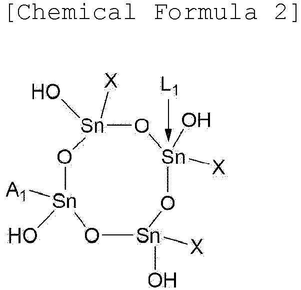

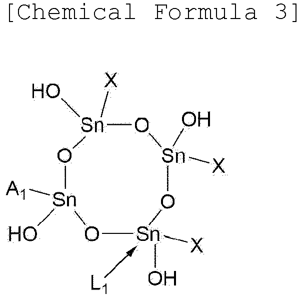

wherein X is a halogen, A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and L₁ is a neutral or ionic ligand.

Since the cluster compound or the salt thereof according to an example embodiment has significantly improved EUV sensitivity while securing chemical stability by introducing a molecule which has no Sn-C bond and is easy to bond and dissociate to the surface of a cluster, it may form a photoresist pattern with excellent sensitivity.

Specifically, the cluster compound may proceed more rapidly with a dissociative electron attachment reaction of a metal-nitrogen bond than a conventional metal-carbon bond, by introducing a metal-nitrogen bond and a metal-halogen bond having lower bond dissociation energy than a metal-carbon bond to the surface, during secondary electron collisions caused by EUV (or electron beam) irradiation. Accordingly, organic molecules including a nitrogen atom are more easily removed, which further promotes a crosslinking reaction between clusters to form a photoresist pattern with excellent sensitivity.

In addition, the cluster compound according to an example embodiment has a structure which includes four tin atoms, includes O and/or OH as a bridging ligand, includes a coordination bond formed between nitrogen and tin atoms, and includes an Sn-X (X is a halogen) or Sn-OH bond. In particular, since the compound includes a Sn-OH bond, it increases the density of a thin film by a hydrogen bond between the cluster compounds to suppress diffusion of secondary electrons, and thus, may form a pattern having excellent etching resistance and mechanical strength at a very small thickness even in an ultrafine pattern.

Specifically, in FIG. 16, the cluster compound includes a ring structure in which four tin atoms and four oxygen atoms are alternately bonded, thereby implementing significantly improved etching resistance and mechanical strength as compared with a cluster compound having a diamond-shaped structure or a linear structure. In addition, the size of clusters is reduced by including 4 tin atoms, and LER performance may be improved.

In an example embodiment, A₁ may be a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, but is not necessarily limited thereto. Specifically, A₁ may be a ligand selected from the group consisting of formic acid, C1-C8 carboxylic acid, C1-C6 carboxylic acid, C1-C4 carboxylic acid, C1-C3 carboxylic acid, methacrylic acid, acetic acid, phosphoric acid, sulfuric acid, nitric acid, C1-C8 sulfonic acid, C1-C6 sulfonic acid, C1-C4 sulfonic acid, C1-C3 sulfonic acid, C1-C8 halosulfonic acid, C1-C6 halosulfonic acid, C1-C4 halosulfonic acid, C1-C3 halosulfonic acid, C1-C8 phosphinic acid, C1-C6 phosphinic acid, C1-C4 phosphinic acid, C1-C3 phosphinic acid, C1-C8 halophosphinic acid, C1-C6 halophosphinic acid, C1-C4 halophosphinic acid, C1-C3 halophosphinic acid, C1-C8 phosphonic acid, C1-C6 phosphonic acid, C1-C4 phosphonic acid, C1-C3 phosphonic acid, C1-C8 halophosphonic acid, C1-C6 halophosphonic acid, C1-C4 halophosphonic acid, and C1-C3 halophosphonic acid, and when it corresponds to a non-alkyl organic ligand, it is not limited. For example, A₁ may be acetate (CH₃COO⁻). Since A₁ is a non-alkyl organic ligand, has no Sn-C bond, and has high solubility in an organic solvent, the cluster compound to which A₁ is introduced may implement significantly improved chemical stability and EUV sensitivity.

In an example embodiment, L₁ is a neutral or ionic ligand, and a neutral ligand which may be selected as L₁ may be any one or more selected from the group consisting of pyrazole, imidazole, dimethyl sulfide, benzaldehyde, dimethyl sulfoxide (DMSO), pyrrolidine, n-butylamine, aniline, ethyl benzoate, pyrazine, n-propylamine, formamide, benzonitrile, pyrimidine, ethylene diamine, acetamide, methylformamide, t-butylamine, pyridine, propionitrile, triethylamine, ethylamine, diethylamine, pivalic acid, 2-pyrrolidone, water, diglyme, tetrahydrofuran (TH), nitric acid, benzyl alcohol, t-butanol, ethyl benzene, benzoic acid, n-methylpyrrolidone, acetonitrile, furan, diethylformamide, n-propanol, 2-propanol, ethanol, methanol, trifluoro acetic acid, formic acid, dimethylformamide (DMF), 1,4-dioxane, dimethyl acetamide, acetic acid, 1-butanol, ethylacetate, dimethoxyethane, ethylene glycol, methoxy ethanol, phenol, and diethyl ether, and an anionic ligand may be any one or more selected from the group consisting of SiO₄⁴⁻, pyrazolate⁻, MeS⁻, Me₂dtc⁻, N(EtOH) (EtO)₂²⁻, PhCH₂S⁻, EtOCS²⁻, thioacetate-, N(EtOH)₂(EtO)⁻, salicylate²⁻, CyS⁻, i-Pr₂dtc⁻, O-Et-O²⁻, MeOCS²⁻, SiCl₃⁻, Py(COO)₃³⁻, CH₂S₂²⁻, Et₂NCOO⁻, i-Pr₂NCOO⁻, Si(PhCOO)₄⁴⁻, OCS₂²⁻, H₂-citrate-, H-citrate²⁻, CN⁻, EtS⁻, AsO₄³⁻, AsO₃³⁻, i-PrO⁻, Et₂dtc⁻, i-PrS⁻, pyrrolidine-dtc⁻, O²⁻, PhS⁻, o-PhO₂²⁻, CF₃CF₂COO⁻, o-Ph(CH₂COO)₂²⁻, m-Ph(CH₂COO)₂²⁻, citrate³⁻, N³⁻, PO₄³⁻, OCN⁻, t-BuS⁻, Et-COO⁻, malate-, n-PrO⁻, i-PrOCS²⁻, NO²⁻, glycinate-, SO₃²⁻PhCOO⁻, t-Bu-COO-(pivalate) ⁻, HAsO₄²⁻, PhO⁻, SeO₃²⁻, SCN⁻, N(CH₂COO)₃³⁻, PhCH₂O⁻, MeOCOO⁻, MeO⁻, Ph(COOH)(COO)₂²⁻, i-Pr-COO⁻, furandicarboxylate⁻, NC-N-CN⁻, EtO⁻, HCl₂C-COO⁻, HO-Et-O⁻, m-Ph(COO)₂²⁻, HPO₄²⁻, SeCN⁻, pyrrolate⁻, H₂PO₂²⁻, p-Ph(CH₂COO)₂²⁻, imidazolate⁻, S²⁻, HCOO⁻, Ph(COO)₃³⁻, o-Ph(COO)₂²⁻, n-BuO⁻, CH₃COO⁻, OH⁻, Se²⁻, t-BuO⁻, p-Ph(COO)₂²⁻, N(EtO) ₃³⁻, MeO-Et-O⁻, C₂O₄²⁻, Te²⁻, Cl₃CCOO⁻, Me₃SiO⁻, HO-Ph-COO⁻, CF₃CF₂CF₂COO⁻, GeCl³⁻, Cl⁻, OTeF⁵⁻, EDTA⁴⁻, n-PrCOO⁻, CO₃²⁻, Et(COO)₂²⁻, S₂O₃²⁻, AlMe₄⁻, BH₃CN⁻, Et(COOH) (COO)⁻, Br⁻, I⁻, fumarate²⁻, (O₂N)₂PhCOO⁻, CF₃COO⁻, BH₄⁻, salicyiate⁻, SnCl₃⁻, Ph(COOH)₂(COO)⁻, (MeO)₂PO₂⁻, SH⁻, -OOC-C≡C-COO⁻, Me₂NCOO⁻, H₂PO₄⁻, lactate, p-O₂NPhO⁻, saccharinate-, tartrate²⁻, C(CN)₃⁻, SeO₄²⁻, CH₃SO₃⁻, HCO₃⁻, SO₄²⁻, m-Ph(COOH)(COO)⁻, o-Ph(COOH)(COO)⁻, p-H₂N-Ph-SO₃⁻, Naph(SO₃)₂²⁻, C₂O₄H⁻, ClO₃⁻, HCB₁₁H₁₁⁻, F⁻, NO₃⁻, PhSO₃⁻, B(PhO₂)₂⁻, ReO₄⁻, SiF₆²⁻, p-Ph(COOH)(COO)⁻, p-Me-PhSO₃⁻(OTs), B₁₀H₁₀²⁻, BHEt₃⁻, B(CN)₄⁻, picrate, B₁₂H₁₂²⁻, HCB₁₁H₁₁-xClx⁻, H-tartrate⁻, AlCl₄⁻, CF₃SO₃⁻(triflate), HSO₄⁻, (F₃C)₃C-O⁻, triflimidate⁻, GaCl₄⁻, SbCl₆⁻, ClO₄⁻_{,} S₂O₆²⁻, AsF₆⁻, SbF₆⁻, BF₄⁻, I₃⁻, BH(C₆F₅)₃⁻, B(3,5-PhCl₂)₄⁻, Al(OC(CF₃)₃)₄⁻, BMe(C₆F₅)₃⁻, PF₆⁻, BPh₄⁻, B(C₆F₅)₄⁻, and BArF₄⁻, but is not necessarily limited thereto. For example, L₁ may be any one or more selected from the group consisting of pyrazole (C₃N₂H₄), pyridine (C₅NH₅), and imidazole (C₃N₂H₄).

In an example embodiment, X may be a halogen, but is not necessarily limited thereto, and may be, for example, Cl.

In an example embodiment, the cluster compound may have an average particle diameter of 0.5 nm to 5 nm in an organic solvent. Specifically, the average particle diameter may be 0.5 nm to 3 nm, more specifically 0.8 nm to 1.8 mm, and more specifically 0.8 nm to 1.4 nm, but is not necessarily limited thereto. Herein, the organic solvent may be any one or more selected from 2-methoxyethanol, methylisobutyl carbinol, ether, propylene glycol monomethyl ether, propylene glycol monomethyl ether acetate, ethyl acetate, ethyl lactate, and a mixture thereof, and specifically, ethyl lactate, but is not necessarily limited thereto.

When the photoresist pattern is formed of the cluster compound having the average particle diameter satisfying the range described above in the organic solvent, an exposure area and a non-exposure area are more clearly distinguished, and a photoresist pattern having improved pattern half pitch and LER may be formed.

In an example embodiment, all or a part of X may be substituted by any one or more selected from the group consisting of R₁COO⁻, CO₃²⁻, and HCO₃⁻ in which R₁ is C1-C5 alkyl. Even when X is substituted as such, a Sn-C bond which is not easy to dissociate is not included, and the pattern may be formed with high sensitivity.

As the molecules on the surface of the cluster compound dissociate during exposure to form crosslinking between the clusters, the compound has characteristics of showing a solubility difference in a developing solution depending on exposure, and thus, it may be for forming a photoresist pattern, and specifically, the photoresist pattern may be an EUV photoresist pattern. Since the compound has significantly improved EUV sensitivity while securing chemical stability of the cluster compound by introducing a surface molecule which is easy to bond and dissociate, as described above, it may form the photoresist pattern with excellent sensitivity. In addition, the compound is an inorganic material, and when it is used as a photoresist, it may be formed at a very small thickness even in an ultrafine pattern due to the excellent etching resistance and mechanical strength, and thus, a pattern collapse problem may be prevented.

In an example embodiment, the cluster compound may be for forming a photoresist pattern.

In an example embodiment, the photoresist pattern may be an EUV photoresist pattern.

Another example embodiment provides a photoresist composition including the cluster compound or a salt thereof. The photoresist composition according to an example embodiment includes a cluster compound having significantly improved EUV sensitivity while having excellent etching resistance and mechanical strength, thereby preventing a pattern collapse problem and forming the photoresist pattern with excellent sensitivity. Herein, since the above descriptions of the cluster compound or the salt thereof may be applied identically to the cluster compound and the salt thereof, repeated descriptions will be omitted below.

Another example embodiment provides a method for preparing a cluster compound or a salt thereof including: 1) preparing a solution including a tin halogen compound, water, and a neutral or ionic ligand; and 2) dissolving the solution in a solvent to prepare a cluster compound represented by any one of the following Chemical Formulae 1 to 3 or a salt thereof:

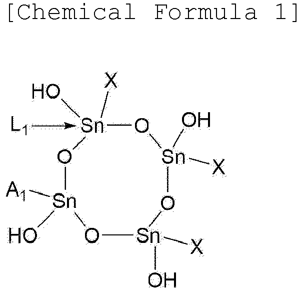

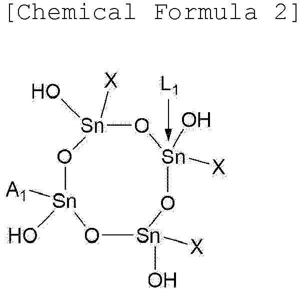

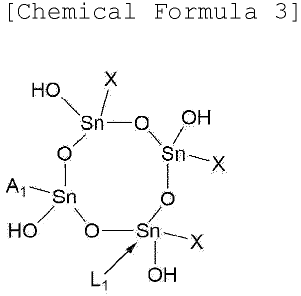

wherein X is a halogen, A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and L₁ is a neutral or ionic ligand.

Herein, the above descriptions of the cluster compound or the salt may be applied identically to the cluster compound represented by any one of Chemical Formulae 1 to 3 or the salt thereof, and the repeated descriptions will be omitted below.

In an example embodiment, the neutral or ionic ligand may be any one or more neutral ligands selected from the group consisting of pyrazole, imidazole, dimethyl sulfide, benzaldehyde, dimethyl sulfoxide (DMSO), pyrrolidine, n-butylamine, aniline, ethyl benzoate, pyrazine, n-propylamine, formamide, benzonitrile, pyrimidine, ethylene diamine, acetamide, methylformamide, t-butylamine, pyridine, propionitrile, triethylamine, ethylamine, diethylamine, pivalic acid, 2-pyrrolidone, water, diglyme, tetrahydrofuran (THF), nitric acid, benzyl alcohol, t-butanol, ethyl benzene, benzoic acid, n-methylpyrrolidone, acetonitrile, furan, diethylformamide, n-propanol, 2-propanol, ethanol, methanol, trifluoro acetic acid, formic acid, dimethylformamide DMF, 1,4-dioxane, dimethyl acetamide, acetic acid, 1-butanol, ethylacetate, dimethoxyethane, ethylene glycol, methoxy ethanol, phenol, and diethyl ether, or any one or more anionic ligands selected from the group consisting of SiO₄⁴⁻, pyrazolate⁻, MeS⁻, Me₂dtc⁻, N(EtOH)(EtO)₂²⁻, PhCH₂S⁻, EtOCS²⁻, thioacetate-, N(EtOH)₂(EtO)⁻, salicylate²⁻, CyS⁻, i-Pr₂dtc⁻, O-Et-O²⁻, MeOCS²⁻, SiCl₃⁻, Py(COO-)₃³⁻, CH₂S₂²⁻, Et₂NCOO⁻, i-Pr₂NCOO⁻, Si(PhCOO)₄⁴⁻, OCS₂²⁻, H₂-citrate⁻, H-citrate²⁻, CN⁻, EtS⁻, AsO₄³⁻, AsO₃³⁻, i-PrO⁻, Et₂dtc⁻, i-PrS⁻, pyrrolidine-dtc⁻, O²⁻, PhS⁻, o-PhO₂²⁻, CF₃CF₂COO⁻, o-Ph(CH₂COO)₂²⁻, m-Ph(CH₂COO)₂²⁻, citrate³⁻, N³⁻, PO₄³⁻, OCN⁻, t-BuS⁻, Et-COO⁻, malate-, n-PrO⁻, i-PrOCS²⁻, NO²⁻, glycinate-, SO₃²⁻, PhCOO⁻, t-Bu-COO-(pivalate) ⁻, HAsO₄²⁻, PhO⁻, SeO₃²⁻, SCN⁻, N(CH₂COO)₃³⁻, PhCH₂O⁻, MeOCOO⁻, MeO⁻, Ph(COOH)(COO)₂²⁻, i-Pr-COO⁻, furandicarboxylate⁻, NC-N-CN⁻, EtO⁻, HCl₂C-COO⁻, HO-Et-O⁻, m-Ph(COO)₂²⁻, HPO₄²⁻, SeCN⁻, pyrrolate⁻, H₂PO₂²⁻, p-Ph(CH₂COO)₂²⁻, imidazolate⁻, S²⁻, HCOO⁻, Ph(COO)₃³⁻, o-Ph(COO)₂²⁻, n-BuO⁻, CH₃COO⁻, OH⁻, Se²⁻, t-BuO⁻, p-Ph(COO)₂²⁻, N(EtO)₃³⁻, MeO-Et-O⁻, C₂O₄²⁻, Te²⁻, Cl₃CCOO⁻, Me₃SiO⁻, HO-Ph-COO⁻, CF₃CF₂CF₂COO⁻, GeCl³⁻, Cl⁻, OTeF⁵⁻, EDTA⁴⁻, n-PrCOO⁻, CO₃²⁻, Et(COO)₂²⁻, S₂O₃²⁻, AlMe₄⁻, BH₃CN⁻, Et(COOH) (COO)⁻, Br⁻, I⁻, fumarate²⁻, (O₂N)₂PhCOO⁻, CF₃COO⁻, BH₄⁻, salicyiate⁻, SnCl₃⁻, Ph(COOH)₂(COO)⁻, (MeO)₂PO₂⁻, SH⁻, -OOC-C≡C-COO⁻, Me₂NCOO⁻, H₂PO₄⁻, lactate-, p-O₂NPhO⁻, saccharinate-, tartrate²⁻, C(CN)₃⁻, SeO₄²⁻, CH₃SO₃⁻, HCO₃⁻, SO₄²⁻, m-Ph(COOH) (COO)⁻, o-Ph(COOH)(COO)⁻, p-H₂N-Ph-SO3⁻, Naph(SO₃)2²⁻, C₂O₄H⁻, ClO₃⁻, HCB₁₁H₁₁⁻, F⁻, NO₃⁻, PhSO₃⁻, B(PhO₂)₂⁻, ReO₄⁻, SiF₆²⁻, p-Ph(COOH)(COO)⁻, p-Me-PhSO₃⁻(OTs), B₁₀H₁₀²⁻, BHEt₃⁻, B(CN)₄⁻, picrate, B₁₂H₁₂²⁻, HCB₁₁H₁₁-xClx⁻, H-tartrate-, AlCl₄⁻, CF₃SO₃⁻(triflate), HSO₄⁻, (F₃C)₃C-O⁻, triflimidate⁻, GaCl₄⁻, SbCl₆⁻, ClO₄⁻, S₂O₆²⁻, AsF₆⁻, SbF₆⁻, BF₄⁻, I₃⁻, BH(C₆F₅)₃⁻, B(3,5-PhCl₂)₄⁻, Al(OC(CF₃)₃)₄⁻, BMe(C₆F₅)₃⁻, PF₆⁻, BPh₄⁻, B(C₆F₅)₄⁻, and BArF₄⁻, but is not necessarily limited thereto. For example, it may be any one or more selected from the group consisting of pyrazole (C₃N₂H₄), pyridine (C₅NH₅), and imidazole (C₃N₂H₄).

In an example embodiment, the solvent may include any one or more selected from the group consisting of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, but is not necessarily limited thereto. Specifically, the solvent may include any one or more selected from the group consisting of formic acid, C1-C8 carboxylic acid, C1-C6 carboxylic acid, C1-C4 carboxylic acid, C1-C3 carboxylic acid, methacrylic acid, acetic acid, phosphoric acid, sulfuric acid, nitric acid, C1-C8 sulfonic acid, C1-C6 sulfonic acid, C1-C4 sulfonic acid, C1-C3 sulfonic acid, C1-C8 halosulfonic acid, C1-C6 halosulfonic acid, C1-C4 halosulfonic acid, C1-C3 halosulfonic acid, C1-C8 phosphinic acid, C1-C6 phosphinic acid, C1-C4 phosphinic acid, C1-C3 phosphinic acid, C1-C8 halophosphinic acid, C1-C6 halophosphinic acid, C1-C4 halophosphinic acid, C1-C3 halophosphinic acid, C1-C8 phosphonic acid, C1-C6 phosphonic acid, C1-C4 phosphonic acid, C1-C3 phosphonic acid, C1-C8 halophosphonic acid, C1-C6 halophosphonic acid, C1-C4 halophosphonic acid, and C1-C3 halophosphonic acid, and for example, may include acetic acid or methacrylic acid.

In addition, the solvent may further include any one or more selected from the group consisting of ethyl lactate, 2-methoxyethanol, methylisobutylketone, methyl ethyl ketone, water, methanol, ethanol, propanol, isopropanol, butanol, dimethylsulfoxide, dimethylformamide, acetone, and tetrahydrofuran as a mixed solvent, but is not necessarily limited thereto.

In an example embodiment, the tin halogen compound may be included at 0.01 mol to 1 mol with respect to 1 mol of the neutral or ionic ligand. Specifically, the tin halogen compound may be included at 0.05 mol to 1 mol or 0.05 mol to 0.5 mol, but is not necessarily limited thereto.

Another example embodiment provides a method for forming a photoresist pattern including: (a) applying the photoresist composition of claim 8 on a substrate and drying to form a photoresist film; (b) exposing the photoresist film to active light; and (c) developing the exposed photoresist film. Herein, the above description of the photoresist composition may be applied identically to the photoresist composition, and the repeated description will be omitted below.

In an example embodiment, a substrate on which the photoresist composition is applied may include one or more conductive layers selected from aluminum, copper, molybdenum, titanium, tungsten, an alloy of these metals, nitrides of these metals, or silicides of these metals placed on a lower base substrate, one or more dielectric layers selected from silicon oxide, silicon nitride, silicon oxynitride, and metal oxide, a semiconductor layer such as monocrystalline silicon, and a combination thereof, but is not necessarily limited thereto.

Herein, the lower base substrate may have a wafer or film shape, and may be a laminate in which semiconductor, ceramic, metal, polymer, or two or more materials selected therefrom form each layer and are laminated. For example, the lower base substrate may be a semiconductor substrate, and a non-limiting example of the semiconductor substrate may be a laminate in which a Group 4 semiconductor including silicon (Si), germanium (Ge), or silicon germanium (SiGe), a Group 3-5 semiconductor including gallium arsenide (GaAs), indium phosphide (InP), or gallium phosphide (GaP), a Group 2-6 semiconductor including cadmium sulfide (CdS) or zinc telluride (ZnTe), a Group 4-6 semiconductor including lead sulfide (PbS), or two or more materials selected therefrom form each layer and are laminated.

In an example embodiment, when the photoresist composition is applied on the substrate for forming the photoresist film in step (a), the composition may be applied using any method known in the art without limitation, and for example, may be applied using a method such as spin coating, dipping, roller coating, bar coating, spray coating, inkjet printing, and screen printing, but is not limited thereto. Specifically, as an example, the photoresist composition may be applied on a substrate by a spin coating method, and herein, the thickness of the photoresist film to be desired may be adjusted based on a spinner speed and a coating time. For example, spin coating may be performed at a speed of 1000 rpm to 5000 rpm, specifically 2000 rpm to 4000 rpm for 10 second to 60 seconds, specifically 20 seconds to 40 seconds, but is not necessarily limited thereto.

In an example embodiment, a post apply bake (PAB) process step of baking the photoresist film may be further included before step (b), and the PAB process may improve adhesive strength between the photoresist film and the substrate by removing a solvent included in the photoresist composition. As an example, the PAB process may be performed at a temperature of 100°C to 200°C, specifically 120 °C to 180°C for 1 minute to 10 minutes, specifically 1 minute to 5 minutes, but is not necessarily limited thereto, and the process conditions may be changed depending on the used solvent.

In an example embodiment, the photoresist film formed on the substrate may have a thickness of 1 nm to 100 nm, specifically 10 nm to 50 nm, more specifically 25 nm to 45 nm, but is not particularly limited thereto. Herein, the thickness of the photoresist film may be measured after applying the photoresist composition on the substrate and then performing the PAB process.

Since the etching resistance and the mechanical strength of the photoresist film are formed from the cluster compound, a pattern collapse problem does not occur even at the thickness in the range described above, and the photoresist pattern may be formed with excellent resolution and sensitivity.

In an example embodiment, the photoresist film is exposed to light used in the exposure process described later and becomes a positive type which is soluble in a developing solution or a negative type which is insoluble in a developing solution, and specifically, may be a negative type. That is, a pattern formed by the method for forming a photoresist pattern depending on the solubility in the developing solution of the photoresist film may be a positive type or a negative pattern, and specifically, a negative pattern.

In an example embodiment, (b) is a step of exposing the photoresist film to active light, and the active light may be any one or more selected from electron beam (E-beam), extreme ultraviolet (EUV) rays, I-line, krypton fluoride (KrF) laser, argon fluoride (ArF) laser, deep ultraviolet (DUV) rays, vacuum ultraviolet (VUV) rays, X-rays, and ion beam, and specifically, may be an electron beam or an extreme ultraviolet (EUV) rays.

In an example embodiment, a post exposure bake (PEB) process step of baking the exposed photoresist film may be further included after the step (b), and the PEB process may further increase a solubility difference in a developing solution between an exposed area and an unexposed area. As an example, the PEB process may be performed at a temperature of 100°C to 250 °C, specifically 120 °C to 230 °C for 1 minute to 15 minutes, specifically 1 minute to 10 minutes, but is not limited thereto.

In an example embodiment, (c) is a step of developing the exposed photoresist film, and specific development may be performed using a developing solution including any one or a combination of two or more selected from the group consisting of a quaternary ammonium salt, alcohol, ketone, and distilled water. A specific example of the quaternary ammonium salt may be tetramethylammonium hydroxide (TMAH), tetrabutylammonium hydroxide (TBAH), tetrapropylammonium hydroxide (TPAH), tetraethylammonium hydroxide (TEAH), or a mixture thereof. As an example, the developing solution may include 0.01 to 10 wt%, specifically 0.01 to 5 wt% of the quaternary ammonium salt.

Another example embodiment provides a semiconductor device including a photoresist pattern formed by the method for forming a photoresist pattern. Herein, the above descriptions of the method for forming a photoresist pattern and the photoresist pattern may be applied identically to the method for forming a photoresist pattern and the photoresist pattern, and repeated description will be omitted below.

In an example embodiment, the semiconductor device may implement better performance by including the photoresist pattern formed with excellent resolution, LER, and sensitivity by the method described above, and does not damage a lower layer during manufacture of the device.

Hereinafter, the examples will be further described with reference to the specific experimental examples. It is apparent to those skilled in the art that the examples and the comparative examples included in the experimental examples only illustrate an example embodiment and do not limit the appended claims, and various modifications and alterations of the examples may be made within the range of the scope and spirit of the present disclosure, and these modifications and alterations will fall within the appended claims.

### <Preparation Example 1> Preparation of tin oxide cluster compound

20 g (290 mmol, 1.0 eq) of pyrazole and 32 g (140 mmol, 0.48 eq) of tin(II) chloride dihydrate (SnCl₂·2H₂O) were added to 80 ml of tetrahydrofuran (THF), refluxing with stirring was performed for 24 hours at a bath temperature set to 110°C, the formed solid was filtered, the filtrate was taken, and then refluxing with stirring was performed again at a bath temperature of 110°C for 48 hours. After the reaction was completed, the mixture was concentrated under reduced pressure to remove THF as a reaction solvent as much as possible. 100 ml of isopropyl alcohol (IPA) was added to the obtained solid mixture, and stirring was performed at room temperature for 1 hour. After finishing the stirring, an acetone mixed solution was centrifugated to remove impurities. The acetone solution obtained after centrifugation was filtered with a PTFE filter and concentrated under reduced pressure at 25°C or lower to prepare 26 g of a tin oxide cluster compound.

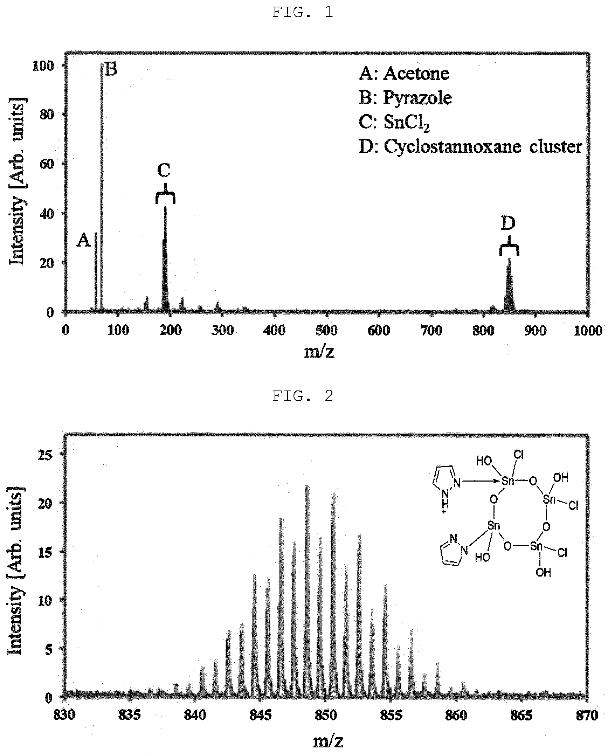

The molecular structure of the tin oxide cluster compound prepared in Preparation Example 1 was analyzed by a field desorption mass spectrometer and the results are shown in FIG. 1. In particular, the peak shown in 840 Da to 860 Da was enlarged and is shown in FIG. 2, and it was found that there was Sn₄Cl₃ (theoretical maximum peak: 580.526 Da) in the cluster compound, as shown in FIG. 2. In summary, it was confirmed that the cluster compound of Preparation Example 1 had the molecular formula of Sn₄Cl₃(C₃N₂H₃)O₄(OH)₄[C₃N₂H₄].

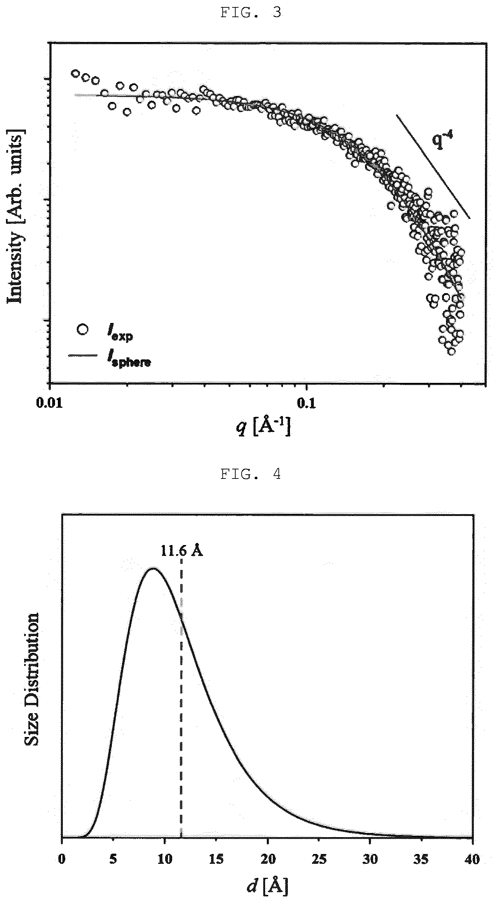

In addition, the results of analyzing the stereoscopic structure of the cluster compound of Preparation Example 1 through small-angle X-ray scattering (SAXS) are shown in FIG. 3, and in FIG. 4, the results were converted into a log scale and shown in a particle size distribution. In FIG. 3, it is shown that the cluster compound according to Preparation Example 1 maintained constant strength in a Guinier region of a low scattering vector (q) value and then decreased proportionally to q⁻⁴ in a high scattering vector region. This shows that the cluster compound particles of Preparation Example 1 were close to a spherical shape and did not have a chain structure at least. In addition, considering that the shape of the graph of FIG. 3 is disordered in the high scattering vector region, the structure of the cluster compound was not uniform and in a state in which several structural isomers were mixed.

### <Example 1> Preparation of cluster compound having substituted ligand

0.5 g of acetic acid and 9.5 g of ethyl lactate were mixed to prepare 10 g of a mixed solvent. The cluster compound of Preparation Example 1 was dissolved to 3 wt% in the mixed solvent to prepare a cluster compound (Sn₄Cl₃(CH₃COO)O₄(OH)₄[C₃N₂H₄]) in which the ligand was substituted with acetic acid.

The results of analyzing the molecular structure of the cluster compound prepared in Example 1 through a field desorption mass spectrometer are shown in FIG. 5, and in particular, the results in an area from 825 Da to 867 Da are shown in (a) to (d) of FIG. 6. Specifically, since the ligand of some cluster compounds was present in a state of being unsubstituted in Example 1, FIG. 5 shows a state in which the peak of the compound having a substituted ligand and the peak of the compound having an unsubstituted ligand were mixed. Accordingly, (a) and (b) of FIG. 6 show the peak simulated by fitting depending on an existence ratio between the compound having an unsubstituted ligand and the compound having a substituted ligand, respectively. As compared with (a) and (b) of FIG. 6, in (b) of FIG. 6 in which the peak of the cluster compound having a substituted ligand was simulated, the peak was detected in a position decreased by 8 Da from the peak of the cluster compound having an unsubstituted ligand (see (a) of FIG. 6). Therefore, it was confirmed from fitting that a molecular weight difference between pyrazole and acetic acid was 8 Da and the compound having an unsubstituted ligand and the compound having a substituted ligand exist at a ratio of about 17:25, and thus, it was found that the ligand of the cluster compound was substituted with acetic acid in Example 1.

Meanwhile, the substitution reaction of the metal cluster underwent an S_{N}1 or S_{N}2 exchange reaction or an association reaction, and since in FIG. 6, a peak near 820 Da was a peak in which one chlorine atom in the cluster compound dissociated and there was no peak in 790 to 800 Da, the substitution reaction of the cluster compound of Example 1 was not an SN₁ type. Likewise, considering that there was no peak in 900 to 910 Da, it was found that the substitution reaction of the cluster compound prepared in Example 1 was not an association reaction, and thus, the substitution reaction was an S_{N}2 type. FIG. 7 shows that when a ligand is substituted with acetic acid, the S_{N}2 type substitution reaction is impossible in a diamond structure and possible in a ring structure. Therefore, it was found from FIG. 7 that since the substitution reaction is impossible in a diamond structure and possible in a ring structure, the cluster compound prepared in Example 1 was a ring structure.

### <Example 2> Preparation of cluster compound having substituted ligand

A cluster compound (Sn₄Cl₃(CH₂C(CH₃)COO)O₄(OH)₄[C₃N₂H₄]) in which the ligand was substituted with methacrylic acid was prepared in the same manner as in Example 1, except that the mixing was performed using methacrylic acid (product name) instead of acetic acid.

### <Example 3> Manufacture of photoresist film

A p-type silicon wafer on which a thermal oxidation film (SiO₂) having a thickness of 100 nm was deposited was cut into a size of 1 cm×1 cm, sonicated with acetone for 20 minutes, and washed to manufacture a SiO₂/Si substrate. The compound of Example 1 was spin coated on the manufactured SiO₂/Si substrate under the conditions of 3000 rpm/30 seconds to manufacture a thin film.

### <Example 4> Manufacture of photoresist film

A photoresist film was manufactured in the same manner as in Example 3, except that spin coating was performed using the compound of Example 2 instead of the compound of Example 1.

### <Experimental Example 1> Pattern formation using electron beam

The photoresist films manufactured in Examples 3 and 4 were baked at 200°C for 2 minutes (baked after application, post-apply bake, PAB) and were irradiated with 5 kV of an electron beam with an increasing light exposure amount by 1.1 times from 1 µC/cm² to 1051 µC/cm². Thereafter, the thin film was baked at 200°C for 1 minute (baked after exposure, post-exposure bake, PEB), developed with 2.38 wt% of tetramethylammonium hydroxide for 20 seconds, and then washed with distilled water to form a final pattern.

At this time, the shapes of the pattern formed on the photoresist films according to Examples 3 and 4 are shown in FIG. 8 and 9, respectively, and the following Table 1 shows the D₅₀ and contrast values depending on the pattern formation. The D₅₀ value refers to an exposure dose (dose) when the pattern thickness was 50% of the thickness before exposure, and the contrast value refers to a slope of the pattern thickness graph depending on the exposure dose. The pattern thickness was the thickness of the thin film after completing washing and was measured with an atomic force microscope (AFM) .

**[Table 1]**

| Example | D50 (µC/cm²) | contrast (γ) |
|---|---|---|
| Example 3 | 19 | 2.4 |
| Example 4 | 155 | 3.5 |

### <Experimental Example 2> Pattern formation using EUV

The photoresist film manufactured in Example 3 was baked at 200°C for 2 minutes (baked after application, post-apply bake (PAB)) and irradiated with extreme ultraviolet (EUV) rays with a linearly increasing exposure dose from 35 mJ/cm² to 105 mJ/cm². Thereafter, the thin film was baked at 200°C for 1 minute (baked after exposure, post-exposure bake, PEB), developed with 2.38 wt% of tetramethylammonium hydroxide (TMAH) for 20 seconds, and then washed with distilled water to form a final pattern.

The SEM images of the patterns formed by the process are shown in FIGS. 10 to 15. Specifically, FIGS. 10 to 12 show 15 nm, 18 nm, and 22 nm half pitch patterns with an exposure dose of 45 mJ/cm², respectively, and FIGS. 13 to 15 show 15 nm, 18 nm, and 22 nm half pitch patterns with an exposure dose of 55 mJ/cm², respectively.

The present disclosure relates to a cluster compound or a salt thereof, and a photoresist composition including the same, and the cluster compound according to an example embodiment has excellent etching resistance and mechanical strength by having a ring structure and may be formed at a very thin thickness even in an ultrafine pattern, and thus, may prevent a pattern collapse problem. In addition, by introducing a non-alkyl organic ligand, the cluster compound has high solubility in an organic solvent, secures chemical stability, has significantly improved EUV sensitivity, and thus, may form a photoresist pattern with excellent sensitivity.

The above description is only an example to which the principle of the present disclosure is applied, and other constitutions may be further included without departing from the scope of the present disclosure. Hereinabove, though an implementation has been described in detail by the examples and the experimental examples, the scope of an implementation is not limited to specific examples and should be construed by the appended claims.

## Claims

1. A cluster compound represented by any one of the following Chemical Formulae 1 to 3 or a salt thereof: 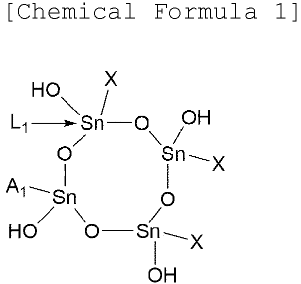 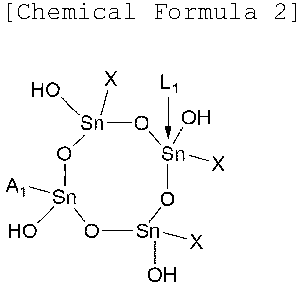 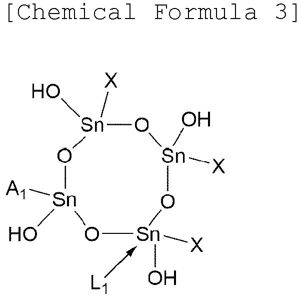 wherein
X is a halogen,
A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and
L₁ is a neutral or ionic ligand.

2. The cluster compound or the salt thereof of claim 1,
wherein A₁ is acetate (CH₃COO⁻).

3. The cluster compound or the salt thereof of claim 1,
wherein L₁ is any one or more selected from the group consisting of pyrazole (C₃N₂H₄), pyridine (C₅NH₅), and imidazole (C₃N₂H₄).

4. The cluster compound or the salt thereof of claim 1,
wherein the cluster compound or the salt thereof has an average particle diameter of 0.5 nm to 5 nm in an organic solvent.

5. The cluster compound or the salt thereof of claim 1,
wherein all or a part of X is substituted by any one or more selected from the group consisting of R₁COO⁻, CO₃²⁻, and HCO₃⁻ in which R₁ is C1-C5 alkyl.

6. The cluster compound or the salt thereof of claim 1,
wherein the cluster compound is for forming an EUV photoresist pattern.

7. A photoresist composition comprising the cluster compound or the salt thereof of any one of claims 1 to 6.

8. A method for preparing a cluster compound or a salt thereof, the method comprising:
1) preparing a solution including a tin halogen compound, water, and a neutral or ionic ligand; and
2) dissolving the solution in a solvent to prepare a cluster compound represented by any one of the following Chemical Formulae 1 to 3 or a salt thereof: 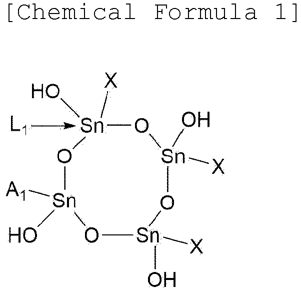 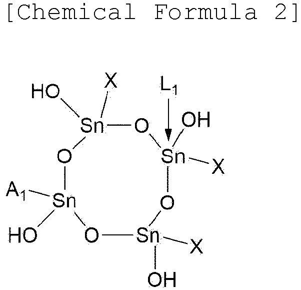 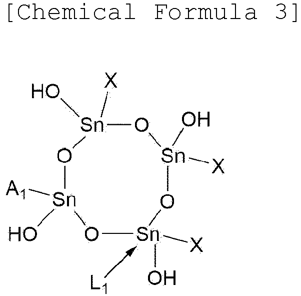 wherein
X is a halogen,
A₁ is a ligand selected from the group consisting of conjugate bases of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid, and
L₁ is a neutral or ionic ligand.

9. The method for preparing a cluster compound or a salt thereof of claim 8, wherein the neutral or ionic ligand is any one or more selected from the group consisting of pyrazole (C₃N₂H₄), pyridine (C₅NH₅), and imidazole (C₃N₂H₄).

10. The method for preparing a cluster compound or a salt thereof of claim 8, wherein the solvent includes any one or more selected from the group consisting of formic acid, C1-C10 carboxylic acid, phosphoric acid, sulfuric acid, nitric acid, C1-C10 sulfonic acid, C1-C10 halosulfonic acid, C1-C10 phosphinic acid, C1-C10 halophosphinic acid, C1-C10 phosphonic acid, and C1-C10 halophosphonic acid.

11. The method for preparing a cluster compound or a salt thereof of claim 8, wherein the tin halogen compound is included at 0.01 mol to 1 mol with respect to 1 mol of the neutral or ionic ligand.

12. A method for forming a photoresist pattern, the method comprising:
(a) applying the photoresist composition of claim 7 on a substrate and drying to form a photoresist film;
(b) exposing the photoresist film to active light; and
(c) developing the exposed photoresist film.

13. The method for forming a photoresist pattern of claim 12, wherein the pattern is a negative pattern.

14. The method for forming a photoresist pattern of claim 12, wherein the active light is an electron beam or extreme ultraviolet rays.

15. A semiconductor device comprising the photoresist pattern formed by the method for forming a photoresist pattern of any one of claims 12 to 14.
